# EUROPÄISCHE PATENTSCHRIFT

(11) **EP 1 402 584 B1**
(45) Veröffentlichungstag und Bekanntmachung des Hinweises auf die Patenterteilung: **18.02.2009**
(21) Anmeldenummer: 02780922.7
(22) Anmeldetag: 09.04.2002
(51) Int. Cl.: H01L 43/04, H01L 21/60

(54) **ANORDNUNG ZUR VERMINDERUNG VON PIEZOEFFEKTEN IN MINDESTENS EINEM IN EINER AKTIVEN HALBLEITERMATERIALSCHICHT ANGEORDNETEN PIEZOEFFEKT-EMPFINDLICHEN, ELEKTRISCHEN BAUELEMENT**
ARRANGEMENT FOR REDUCING THE PIEZOELECTRIC EFFECTS IN AT LEAST ONE ELECTRICAL COMPONENT WHICH IS SENSITIVE TO PIEZOELECTRIC EFFECTS AND ARRANGED IN AN ACTIVE LAYER OF SEMICONDUCTOR MATERIAL
DISPOSITION POUR DIMINUER LES EFFETS PIEZOELECTRIQUES DANS AU MOINS UN COMPOSANT ELECTRIQUE, SENSIBLE AUX EFFETS PIEZOELECTRIQUES ET DISPOSE DANS UNE COUCHE ACTIVE DE MATERIAU SEMI-CONDUCTEUR

(30) Priorität: 27.06.2001 DE 10130591
(43) Veröffentlichungstag der Anmeldung: 31.03.2004
(73) Patentinhaber: Landis+Gyr AG, 6301 Zug (CH)
(72) Erfinder: PETR, Jan, CH-6317 Oberwil (CH)
(74) Vertreter: Lagler, Louis
(86) Internationale Anmeldenummer: PCT/IB2002/001211
(87) Internationale Veröffentlichungsnummer: WO 2003/003480

(56) Entgegenhaltungen:
- US-A- 4 123 772
- US-A- 4 423 434
- TUMMALA R R; RYMASZEWSKI E J; EDITORS: "Microelectronics Packaging Handbook" 1989 , VAN NOSTRAND REINHOLD , NEW YORK XP002214184 ISBN: 0-442-20578-3 Seite 367-371 Seite 541
- PATENT ABSTRACTS OF JAPAN vol. 010, no. 240 (E-429), 19. August 1986 (1986-08-19) & JP 61 071666 A (ASAHI KASEI DENSHI KK;OTHERS: 01), 12. April 1986 (1986-04-12)

## Beschreibung

Die Erfindung ist dem Gebiet der Messtechnik und im besonderen dem Gebiet der Zählertechnik zuzuordnen. Sie bezieht sich auf eine Anordnung zur Verminderung von Piezoeffekten in mindestens einem in einer aktiven Halbleitermaterialschicht angeordneten Hallelement gemäss dem Oberbegriff des Anspruchs 1. Eine solche Anordnung ist z.B. aus US-A-4 123 772 bekannt.

### STAND DER TECHNIK

Die Parameter der meisten in einer aktiven Halbleitermaterialschicht integrierter elektrischer Bauelemente sind abhängig von mechanischen Spannungen in diesem Halbleitermaterial. Dieses Phänomen ist als Piezoeffekt vor allem bei den im Halbleitermaterial integrierten Widerständen bekannt und ist bei den integrierten Hallelementen besonders ausgeprägt.

Die mechanische Empfindlichkeit der Übertragungseigenschaften der im Halbleitermaterial integrierten Schaltkreise ist vor allem in Zusammenhang mit Packaging (Verpackung) des Halbleitermaterials von Bedeutung. Im Packaging kommen zwangsläufig mehrere unterschiedliche Materialen zusammen. Durch die Unterschiede in der Reaktion der verwendeten Materialien auf die Temperatur, Feuchte und Alterung entstehen im verpackten Halbleitermaterial mechanische Spannungen. Diese mechanischen Spannungen können zu unannehmbaren Langzeihstabilitäts-Problemen führen.

In der meist verbreiteten, preisgünstigsten Art des Packaging ist das Halbleitermaterial mit einem Kunststoff umhüllt. Der grösste Anteil der mechanischen Spannungen in diesem Packaging ist auf die Veränderungen im Kunststoffmaterial der Umhüllung zurückzuführen. Auch unter Anwendung von sogenannten "Low-Stress-Plastic-Materials" ist die Stabilität der im Siliziummaterial integrierten Hallelemente problematisch. Für die Anwendung im Elektrizitätszähler ist kein bekannter Kunststoffgehäusetyp brauchbar.

In der teureren, sogenannten hermetischen Art des Packaging sind die mechanischen Spannungen kleiner, da die direkte Umhüllung mit einem Kunststoffmaterial fehlt. Übrig bleiben nur noch die Spannungen, die sich zwischen dem Halbleiter-Chip und der Auflagefläche (Trägermaterial) des Packaging einstellen. Bei hohen Anforderungen an die Stabilität sind aber auch diese Spannungen nicht tolerierbar. Um diese mechanischen Spannungen zwischen Halbleitermaterial und Trägermaterial zu reduzieren, kann man auf die in der Druckschrift EP 0 342 274 B1 beschriebene Anordnung zurückgreifen. Hier ist das Halbleitermaterial nur teilweise mit dem Substrat verbunden. Derjenige Teil des Halbleitermaterials, der das piezoeffekt-empfindliche Schaltungsteil umfasst, weist einen Zwischenraum zu dem Trägermaterial auf. Nicht beschrieben in der genannten Druckschrift ist hingegen die elektrische Kontaktierung bzw. Verdrahtung des Halbleitermaterials an die Anschlüsse des Packaging, die aber selbstredend erfolgen muss und somit eine weitere Fixierung des Halbleitermaterials darstellt. In der realen Ausführung ist das Halbleitermaterial doppelt befestigt, zum einen durch das lediglich lokal zu applizierende Verbindungsmaterial auf dem Trägermaterial, und zum anderen durch die elektrische Kontaktierung bzw. Verdrahtung mit einer schaltungstechnischen Umgebung.

Eine weitere preisgünstige immer häufiger angewendete Art des Packaging, bei der man die direkte Umhüllung durch Kunststoff vermeiden kann, ist das sog. "Wafer Level Chip Size Packaging" (WL-CSP). Bei dieser Art des Packaging entstehen die mechanischen Spannungen hauptsächlich in den elektrischen Kontakten zwischen dem Halbleitermaterial und der Leiterplatte an der das Gehäuse montiert ist.

### DARSTELLUNG DER ERFINDUNG

Es ist deshalb Aufgabe der Erfindung eine einfach zu fertigende, preiswerte Chip-Anordnung bereitzustellen, die die negativen Einflüsse montagebedingter Piezoeffekte, insbesondere deren negativen Einfluss auf die Genauigkeit und die Langzeitstabilität einer aus Halbleiterbauelementen hergestellten elektronischen Präzisionsschaltung eliminiert. Die erfindungsgemässe Anordnung soll die piezoeffekt-empfindlichen Hallelemente weitgehend befreien von montagebedingten oder umgebungsbedingten mechanischen Spannungen.

Die Aufgabe der Erfindung wird gelöst durch die Merkmale des Anspruchs 1. Weitere vorteilhafte Ausgestaltungen der Erfindung sind Gegenstand der Unteransprüche.

Der Kern der Erfindung ist darin zu sehen, dass eine aktive Halbleitermaterialschicht der Chip-Anordnung, umfassend ein Hallelement, sowohl mechanisch als auch elektrisch/thermisch auf einem Substrat, beispielsweise eine Leiterplatte, in einem einzigen Arbeitsgang fixierbar ist. Somit ist die Herstellung der erfindungsgemässen Chip-Anordnung massgeblich einfacher, und darüber hinaus ist diese Anordnung schon alleine durch die Einsparung mindestens eines Fertigungsschritts preiswerter gegenüber dem aufgezeigten Stand der Technik, bei dem auf konventionelle Art die Chip-Anordnung einseitig auf ein Substrat geklebt werden muss und anschliessend in einem weiteren Fertigungsschritt elektrisch und/oder thermisch verbunden werden muss. Erfindungswesentlich ist darüber hinaus, dass die Chip-Anordnung im Bereich eines piezoeffekt-empfindlichen Hallelements keine mechanische und elektrische/thermische Kopplung aufweist, womit dieses piezoeffekt-empfindliche, elektrische Bauelement frei bleibt von Krafteinwirkungen aufgrund thermischer oder mechanischer Dilatation.

Eine besonders vorteilhafte Ausgestaltung der Erfindung sieht vor, dass derjenige, erste Bereich der Halbleitermaterialschicht, in dem das piezoeffekt-empfindliche Hallelement angeordnet ist, balkonartig einen weiteren, zweiten Bereich mit den mechanischen und elektrischen/thermischen Kontakten überragt. Balkonartig bedeutet in diesem Zusammenhang, dass der Bereich mit dem Kontakten und der Bereich mit dem Hallelement nebeneinander, quasi in einer Ebenen, angeordnet sind, wobei der Bereich mit diesem Bauelement den Bereich mit diesen Kontakten seitlich überragt.

Von Vorteil ist die Auslegung der aktiven Halbleitermaterialschicht dergestalt, dass sie mittels "Flip-Chip-Bonding" auf dem Substrat - eine Leiterplatte - oberflächenmontierbar ist. Beim Flip-Chip-Bonding werden ungepackte Halbleiter-Bauelemente umgekehrt auf einer Leiterplatte mittels Lötkugeln verbunden.

Bei sehr kleinen Chip-Anordnungen wird mit Vorteil eine Umverdrahtungsschicht zwischen der aktiven Halbleitermaterialschicht und dem Substrat angeordnet, um geeignete Kontaktflächen bereitzustellen, die mit entsprechenden Kontaktflächen auf dem Substrat korrespondieren. Derartige Umverdrahtungsschichten werden zum Beispiel mittels Dünnfilmtechnik auf der Halbleitermaterialschicht aufgebracht.

Gegebenfalls wird ausschliesslich zwischen dem Bereich der Halbleitermaterialschicht mit den Kontakten und dem Substrat ein Füllmaterial eingefügt, das eine mechanische Entlastung der Kontakte gewährleistet.

Besonders vorteilhaft ist, wenn die Kontakte in einer Matrixstruktur - einem sogenannten "Ball-Grid-Array" - angeordnet sind.

### KURZE BESCHREIBUNG DER ZEICHNUNG

In der Zeichnung ist ein Ausführungsbeispiel schematisch und vereinfacht dargestellt.
Es zeigen:
- Fig. 1: eine Schnittdarstellung der erfindungsgemässen Chip-Anordnung entlang der Linie B - B in Fig. 2;
- Fig. 2: Bodenansicht der Chip-Anordnung.

### WEGE ZUR AUSFÜHRUNG DER ERFINDUNG

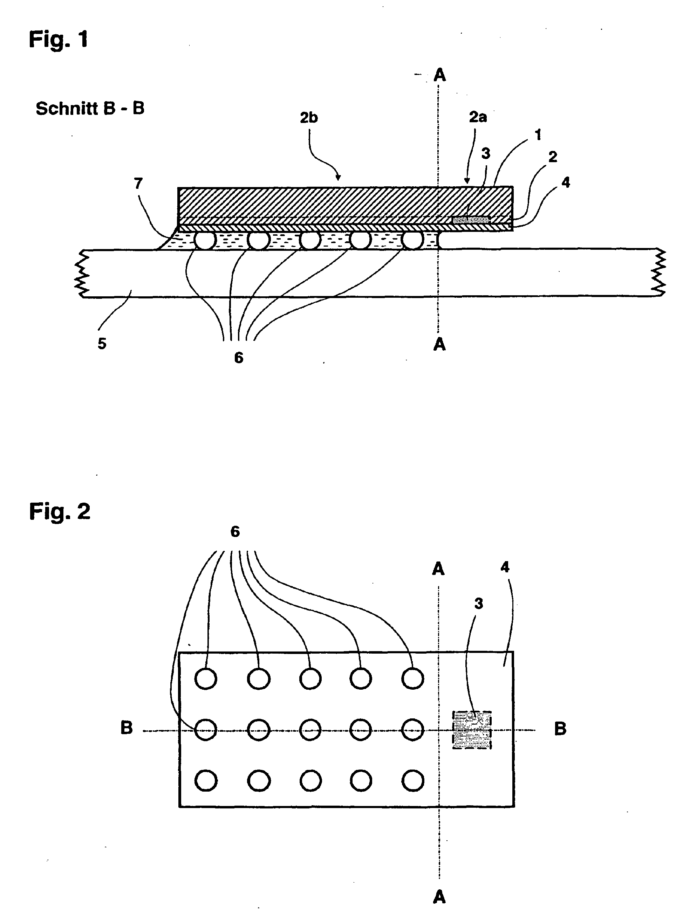

Fig. 1 zeigt eine erfindungsgemässe Chip-Anordnung 1 mit einer aktiven Halbleitermaterialschicht 2. Diese Halbleitermaterialschicht 2 ist durch eine gestrichelte Linie A-A in einen ersten Bereich 2a und einen zweiten Bereich 2b unterteilt. Der erste Bereich 2a umfasst ein Hall-Element. Der zweite Bereich 2b unterscheidet sich von dem ersten Bereich 2a dadurch, dass er elektrische Kontakte 6 aufweist, und dass zumindest kein piezoeffektempfindliches, elektrisches Bauelement in ihm angeordnet ist. Mittels dieser elektrischen Kontakte 6 ist die gesamte Chip-Anordnung 1 mechanisch und elektrisch/thermisch mit einem Substrat 5 verbunden. Ein solches Substrat 5 kann zum Beispiel eine feste oder flexible, hier nicht bis ins Detail gezeigte, Leiterplatte sein.

Zwischen den Kontakten 6 und der aktiven Halbleitermaterialschicht 2 ist eine Umverdrahtungsschicht angeordnet, die die hier nicht näher gezeigten elektrischen Anschlüsse der Halbleitermaterialschicht 2 auf die Geometrie für das Substrat 5 anpasst.

Darüber hinaus ist im zweiten Bereich 2b der Halbleitermaterialschicht 2 eine Füllmaterialschicht - ein sogenannter Underfiller - zwischen der Chip-Anordnung 1 und dem Substrat angeordnet, die Krafteinwirkungen auf die Anordnung aufgrund mechanischer und/oder thermischer Dilatation ausgleicht und damit verringert. Erfindungsgemäss ist diese Füllmaterialschicht lediglich im zweiten Bereich 2b und nicht im ersten Bereich 2a der Halbleitermaterialschicht vorgesehen, damit dieser erste Bereich 2a mit dem Hallelement 3 frei bleibt von jeder montagebedingten Krafteinwirkung. Aus diesem Grund überragt der erste Bereich 2a den zweiten Bereich 2b seitlich balkonartig. Somit ist die Halbleitermaterialschicht 2 in einer einzelnen ebenen Schicht einfach herstellbar und in einem Bereich, dem zweiten Bereich 2b, mechanisch und elektrisch/thermisch montierbar, wobei der erste Bereich 2a ausserhalb jedes mechanischen und/oder thermischen Kraftfeldes bleibt. Die Kontakte 6 erfüllen hier erfindungsgemäss drei Funktionen:
- Die Kontakte 6 stellen eine fest Verbindung zwischen der Chip-Anordnung 1 und dem Substrat 5 her,
- sie dienen als elektrische Schnittstellen zwischen Chip-Anordnung 1 und Substrat 5, und
- sie dienen der Wärmeabfuhr von der Chip-Anordnung 1 zum Substrat 5.

Eine typische Anwendung der erfindungsgemässen Chip-Anordnung 1 ist in der Leistungsmessung für elektronische Elektrizitätszähler zu sehen. Das Hallelement ist ein Sensor, mit dem der Strom und/oder die Spannung gemessen wird. Der Hallsensor ist somit als "analoges Bauelement" in der aktiven Halbleitermaterialschicht 2 anzusehen, dessen intrinsische Parameter bekanntermassen sensibel auf Krafteinwirkungen reagieren. Der diesbezüglich weitaus weniger empfindliche, zweite Bereich 2b - der "digitale Bereich" der Halbleitermaterialschicht 2 - ist mittels der Kontakte 6 auf dem Substrat fixiert.

Die aktive Halbleitermaterialschicht 2 ist so ausgelegt, dass sie mittels "Flip-Chip-Bonding" auf dem Substrat - eine Leiterplatte - oberflächenmontierbar ist. Beim Flip-Chip-Bonding werden ungepackte Halbleiter-Bauelemente umgekehrt auf einer Leiterplatte mittels Lötkugeln verbunden.

Fig. 2 zeigt eine Bodenansicht der Chip-Anordnung 1 mit den in einer Matrix angeordneten Kontakten 6. Wenngleich diese Matrixanordnung gegenüber einer unregelmässigen Anordnung standardmässige Vorteile aufzeigt, ist jedoch jede beliebige Kontaktanordnung denkbar ohne erfinderisches Zutun. Das Hallelement 3 ist aufgrund der Zeichnungsebene nicht unmittelbar sichtbar und somit lediglich gestrichelt angedeutet. Die gestrichelte Linie A-A trennt wiederum den ersten Bereich 2a mit dem Hallelement von dem zweiten Bereich 2b der Halbleitermaterialschicht 2. Die gestrichelte Linie B-B orientiert lediglich über die Schnittebene der Fig. 1.

### BEZUGSZEICHEN

- 1: Chip-Anordnung
- 2: Halbleitermaterialschicht
- 2a: erster Bereich von 2
- 2b: zweiter Bereich von 2
- 3: piezoeffekt-empfindliches Hallelement
- 4: Umverdrahtungsschicht
- 5: Substrat
- 6: elektrische Kontakte
- 7: Füllmaterial
- 8: Zwischenraum

## Patentansprüche

1. Chip-Anordnung zur Verminderung von Piezoeffekten in mindestens einem in einer aktiven Halbleitermaterialschicht (2) angeordneten Hallelement (3), wobei diese aktive Halbleitermaterialschicht (2) mindestens einen ersten Bereich (2a) mit dem Hallelement (3) und einen zweiten Bereich (2b) mit einer Anzahl Kontakten (6) für eine elektrische Kontaktierung umfasst,
und wobei diese aktive Halbleitermateriatschicht (2) im Bereich (2b) der Kontakte (6) mittels einem elektrischen Kontaktmaterial mit einem Substrat (5) mechanisch und elektrisch und/oder thermisch verbunden ist, und der Bereich (2a) mit dem Hallelement (3) von dem Substrat (5) beabstandet ist und zudem frei bleibt von diesem elektrischen Kontaktmaterial,
**dadurch gekennzeichnet,**
**dass** ein Zwischenraum (8) zwischen dem ersten Bereich (2a) der aktiven Halbleitermaterialschicht (2) und dem Substrat (5) derart ausgebildet ist, so dass dieser erste Bereich (2a) mit dem Hallelement (3) den zweiten Bereich (2b) der aktiven Halbleiterschicht (2).seitlich balkonartig überragt.

2. Anordnung nach Anspruch 1, **dadurch gekennzeichnet**, das die Halbleitermaterialschicht (2) derart ausgelegt ist, dass sie mittels Flip-Chip-Bonding auf dem Substrat (5) oberflächenmontierbar ist,

3. Anordnung nach einem der Ansprüche 1 oder 2, **dadurch gekennzeichnet, dass** die aktive Halbleitermaterialschicht (2) zwischen sich und den Kontakten (6) mit einer Umverdrahtungsschicht (4) versehen ist

4. Anordnung nach einem der vorhergehenden Ansprüchen, **dadurch gekennzeichnet, dass** der Zwischenraum (8) nur im Bereich der Kontakte (6) mit einem Füllmaterial (7) ausgefüllt ist zur mechanischen Entlastung der Kontakte (6).

5. Anordnung nach einem der vorhergehenden Ansprüche, **dadurch gekennzeichnet, dass** die Kontakte (6) in einer Matrixstruktur (Ball-Grid-Array) angeordnet sind.

## Claims

1. A chip arrangement for reducing piezoeffects in at least one Hall element (3) arranged in an active semiconductor material layer (2), wherein this active semiconductor material layer (2) comprises at least one first region (2a) with the Hall element (3), and a second region (2b) with a number of contacts (6) for an electrical contacting,
and wherein this active semiconductor material layer (2) in the region (2b) of the contacts (6) is mechanically and electrically and/or thermally connected to a substrate (5) by way of an electrical contact material, and the region (2a) with the Hall element (3) is distanced to the substrate (5) and furthermore remains free of this electric contact material,
**characterised in that**
an intermediate space (8) between the first region (2a) of the active semiconductor material layer (2) and the substrate (5) is designed in a manner such that this first region (2a) with the Hall element (3) projects laterally beyond the second region (2b) of the active semiconductor material layer (2) in a balcony-like manner.

2. An arrangement according to claim 1, **characterised in that** the semiconductor material layer (2) is designed in a manner such that it may be surface-assembled on the substrate (5) by way of flip-chip bonding.

3. An arrangement according to one of the claims 1 or 2, **characterised in that** the active semiconductor material layer (2), between itself and the contacts (6), is provided with a rewiring layer (4).

4. An arrangement according to one of the preceding claims, **characterised in that** the intermediate space (8) is filled out with a filling material (7) only in the region of the contacts (6), for the mechanical relieving of the contacts (6).

5. An arrangement according to one of the preceding claims, **characterised in that** the contacts (6) are arranged in a matrix structure (ball-grid-array.)

## Revendications

1. Dispositif à puce pour diminuer les effets piézoélectriques dans au moins un élément à effet Hall (3) disposé dans une couche active de matériau semi-conducteur (2), cette couche active de matériau semi-conducteur (2) comprenant au moins une première zone (2a) avec l'élément à effet Hall (3) et une deuxième zone (2b) avec une pluralité de contacts (6) pour une mise en contact électrique,
et cette couche active de matériau semi-conducteur (2) étant reliée dans la zone (2b) des contacts (6) mécaniquement et électriquement et/ou thermiquement, au moyen d'un matériau de contact électrique, à un substrat (5), et la zone (2a) avec l'élément à effet Hall (3) étant distante du substrat (5) et restant de plus libre de ce matériau de contact électrique,
**caractérisé en ce**
**qu'**un espace (8) entre la première zone (2a) de la couche active de matériau semi-conducteur (2) et le substrat (5) est conçu de manière que cette première zone (2a) avec l'élément à effet Hall (3) dépasse latéralement de la deuxième zone (2b) de la couche semi-conductrice active (2) à la manière d'un balcon.

2. Dispositif selon la revendication 1, **caractérisé en ce que** la couche de matériau semi-conducteur (2) est conçue de manière à pouvoir être montée en surface sur le substrat (5) par la technique d'assemblage flip chip.

3. Dispositif selon l'une des revendications 1 ou 2, **caractérisé en ce que** la couche active de matériau semi-conducteur (2) est pourvue d'une couche de recâblage (4) entre elle et les contacts (6).

4. Dispositif selon l'une des revendications précédentes, **caractérisé en ce que** l'espace (8) n'est rempli que dans la zone des contacts (6) d'un matériau de remplissage (7) pour la décharge mécanique des contacts (6).

5. Dispositif selon l'une des revendications précédentes, **caractérisé en ce que** les contacts (6) sont disposés selon une structure matricielle (ball grid array).
